# EUROPEAN PATENT SPECIFICATION

(11) **EP 3 162 946 B1**
(45) Date of publication and mention of the grant of the patent: **29.07.2020**
(21) Application number: 16196150.3
(22) Date of filing: 28.10.2016
(51) Int. Cl.: D06F 39/14, D06F 34/28, G06F 3/044

(54) **LAUNDRY TREATING APPARATUS**
WÄSCHEBEHANDLUNGSVORRICHTUNG
APPAREIL DE TRAITEMENT DU LINGE

(30) Priority: 02.11.2015 US 201562249355 P; 05.01.2016 KR 20160001216; 01.04.2016 KR 20160040451
(43) Date of publication of application: 03.05.2017
(73) Proprietor: LG Electronics Inc., Seoul 07336 (KR)
(72) Inventor: CHEON, Kangwoon, 08592 Seoul (KR); YONG, Seungji, 08592 Seoul (KR); KWON, Yongwoo, 08592 Seoul (KR); CHOI, Jaehoon, 08592 Seoul (KR); SON, Junyoung, 08592 Seoul (KR); KIM, Hongchul, 08592 Seoul (KR)
(74) Representative: Vossius & Partner Patentanwälte Rechtsanwälte mbB

(56) References cited:
- WO-A2-2010/128729
- CN-U- 204 298 638
- DE-A1-102013 208 851
- KR-A- 20110 130 089
- KR-A- 20140 015 017
- KR-A- 20150 006 262
- KR-A- 20150 006 264
- KR-A- 20150 090 754
- US-A1- 2014 016 290
- US-A1- 2014 063 367

## Description

### BACKGROUND OF THE INVENTION

This specification relates to a laundry treating apparatus having a door opening/closing a laundry introduction opening of a main body and a method for fabricating the door of the laundry treating apparatus.

A laundry treating apparatus (or a clothes treating apparatus) includes an apparatus for washing laundry, an apparatus for drying laundry, and an apparatus for washing and drying laundry. In the laundry treating apparatus, washing the laundry refers to a stroke of removing contaminants stuck on the laundry through operations of water and detergent, and drying the laundry refers to a stroke of removing moisture contained in the laundry through a hot air supply device provided in the laundry treating apparatus.

A general laundry treating apparatus includes a main body defining an outer appearance and having a laundry introduction opening, a laundry accommodating unit provided in the main body, a driving unit rotating a drum constructing the laundry accommodating unit, a door opening and closing the laundry introduction opening, and a control unit outputting visual information related to strokes processed in the laundry treating apparatus to a user and receiving the user's manipulation.

In the general laundry treating apparatus, the door is designed to open and close the laundry introduction opening and allow the user to see the inner laundry accommodating unit. Also, the control unit is typically installed at the main body, and provided with a plurality of buttons or knobs for briefly outputting only a predecided stroke in an On/Off manner and manipulating such brief output.

The separate configuration of the door and the control unit has interfered with a simple appearance of the laundry treating apparatus, and input and output interfaces between the laundry treating apparatus and the user has no option to stay such a low level.

Accordingly, studies on providing a control unit on a door and implementing the control unit as a touch screen are undergoing. The related technologies are disclosed in Korean Patent Laid-Open No. 10-2011-0130089 (Published on Dec. 5, 2011) and Korean Patent Laid-Open No. 10-2015-0006264 (Published on Jan. 16, 2015). However, the prior art including those Patent Publications has not disclosed an alignment between a door cover and a touch sensor and an alignment between the touch sensor and a display module, which is to be explained later.

In order to configure a touch screen on a door, a touch sensor and a display module should be arranged at a light-transmissive region (transparent region) of a door cover in a corresponding (or aligning) manner. Specifically, in a structure that the touch sensor is separately fabricated from the display module and attached to a rear surface of the door cover, the touch sensor should be attached at an accurate position on the door cover in order to ensure reliability of the touch screen.

As such, what is important in implementing the touch screen is to realize the alignment between the door cover and the touch sensor and the alignment between the touch sensor and the display module. Among others, considering an assembly process, the alignment between the door cover and the touch sensor should first be carried out accurately.

DE 10 2013 208851 A1 relates to a laundry treatment apparatus which can be fed from the front, such as a washing machine or clothes drier, with a control unit for setting an automatically running treatment program, and a door which is hinged at the front of a cabinet-shaped housing and covers the full width of the housing of the door, the laundry deflector projects into the loading opening of the housing and is locked in the closed state.

US 2014/016290 A1 provides a touch panel and a method for manufacturing the same capable of preventing a mis-alignment phenomenon of a transparent substrate by physically supporting the transparent substrate using a mark formed so as to protrude on a window when coupling the window and the transparent substrate to each other.

### SUMMARY OF THE INVENTION

Therefore, an aspect of the detailed description is to provide an alignment structure between a door and a touch sensor and an alignment structure between the touch sensor and a display module for configuring a display portion as a touch screen, when providing on a door a window portion allowing for viewing an inner laundry accommodating unit, and the display portion outputting information processed in a laundry treating apparatus.

Another aspect of the detailed description is to provide a structure capable of preventing components, which are provided to attach a touch sensor to a preset position of a door cover, from being visible at an outside of a door.

Another aspect of the detailed description is to provide a touch sensor on which components for alignment with a door cover are output (indicated).

To achieve these and other advantages and in accordance with the purpose of this specification, as embodied and broadly described herein, there is provided a laundry treating apparatus comprising a main body having a laundry introduction opening, and a door capable of opening and closing the laundry introduction opening, wherein the door comprises: a door cover defining an appearance of the door, and provided with a transparent region, and an opaque region surrounding the transparent region; a display module disposed on a rear surface of the door cover, and capable of outputting visual information through the transparent region; and a touch sensor attached to a rear surface of the door cover and capable of sensing a touch input applied to the transparent region, wherein the touch sensor is provided with an align mark, and the opaque region is provided with a guide mark capable of guiding an attachment position of the touch sensor using the align mark; wherein the guide mark comprises: an opaque portion, and a transparent portion formed to surround the opaque portion and dividing the opaque portion and the opaque region, so that the transparent portion is formed within the opaque region and the opaque region is formed within the transparent region; wherein the align mark is disposed within the opaque portion in an overlapping manner in a state where a front surface of the touch sensor has been attached to the rear surface of the door cover, wherein the door comprises further an opaque shielding member attached to a rear surface of the touch sensor to cover the transparent portion of the guide mark in a state that the front surface of the touch sensor has attached to the rear surface of the door cover, wherein the opaque portion and the opaque shielding member have the same color tone as the opaque region, and wherein the align mark has a different color tone from the opaque portion.

The guide mark may be disposed on at least three points around the transparent region, in a spaced manner.

The align mark may be formed at a corner portion of the touch sensor.

The touch sensor may include a base portion made of a transparent material, a touch pattern portion patterned into a preset pattern on the base portion to sense a touch input applied to the door cover, and a mark portion formed on the base portion and forming the align mark.

The mark portion may be made of the same material as the touch pattern portion, but is electrically separated from the touch pattern portion.

The touch sensor may further include a signal transfer portion electrically connected to the touch pattern portion to form a signal transfer path. The mark portion may be made of the same material as the signal transfer portion.

The door cover may include a cover body made of a transparent material, and a shielding layer disposed to cover a rear surface of the cover body, and forming the opaque region.

The transparent region may be a portion where the shielding layer is not disposed.

Further, in an alternative, the present invention is directed to a laundry treating apparatus comprising a main body having a laundry introduction opening, and a door capable of opening and closing the laundry introduction opening, wherein the door comprises: a door cover defining an appearance of the door, and provided with a transparent region, and an opaque region surrounding the transparent region; a display module disposed on a rear surface of the door cover, and capable of outputting visual information through the transparent region; and a touch sensor attached to a rear surface of the door cover and capable of sensing a touch input applied to the transparent region, wherein the touch sensor is provided with an align mark, and the opaque region is provided with a guide mark capable of guiding an attachment position of the touch sensor using the align mark; wherein the guide mark comprises only a transparent portion formed within the opaque region; wherein the align mark is arranged within the opaque portion in an overlapping manner in a state where a front surface of the touch sensor has been attached to the rear surface of the door cover, wherein the door comprises further an opaque shielding member attached to a rear surface of the touch sensor to cover the transparent portion of the guide mark in a state that the front surface of the touch sensor has attached to the rear surface of the door cover, wherein the align mark and the opaque shielding member have the same color tone as the opaque region.

In the present invention, when a guide mark includes a transparent portion and an opaque portion, the opaque portion has the same color tone as the opaque region. Or, when a guide mark includes only a transparent portion, an align mark has the same color tone as the opaque region. With the configurations, the opaque shielding member is configured to obscure the transparent portion of the guide mark. Accordingly, the components which guide the attachment of the touch sensor onto a preset position of the door cover can be invisible from outside of the door.

Further scope of applicability of the present application will become more apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from the detailed description.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a perspective view of a laundry treating apparatus in accordance with one exemplary embodiment of the present invention;
FIG. 2A is a conceptual view illustrating a state that a laundry introduction opening is open, in response to a primary rotation of a door illustrated in FIG. 1;
FIG. 2B is a conceptual view illustrating a secondarily-rotated state of a door, from the state illustrated in FIG. 2A;
FIG. 3 is a disassembled perspective view of the door illustrated in FIG. 1;
FIG. 4 is a front view of the door illustrated in FIG. 1;
FIG. 5 is a rear view of a door cover illustrated in FIG. 3;
FIG. 6 is a sectional view illustrating a first exemplary embodiment of a door cover, taken along the line A-A' illustrated in FIG. 5;
FIG. 7 is an enlarged view of a part B illustrated in FIG. 5;
FIG. 8 is a sectional view illustrating a second exemplary embodiment of a door cover, taken along the line A-A' illustrated in FIG. 5;
FIG. 9 is a sectional view illustrating a third exemplary embodiment of a door cover, taken along the line A-A' illustrated in FIG. 5;
FIG. 10 is a conceptual view illustrating a door cover and a touch sensor in a separated state at a part C illustrated in FIG. 5;
FIG. 11 is an enlarged view of the part C illustrated in FIG. 5;
FIG. 12 is a conceptual view illustrating a first exemplary embodiment of a structure for alignment between a door cover and a touch sensor illustrated in FIG. 11;
FIG. 13 is a conceptual view illustrating a second exemplary embodiment of a structure for alignment between a door cover and a touch sensor illustrated in FIG. 11;
FIG. 14 is a front view of the touch sensor illustrated in FIG. 11;
FIG. 15 is a sectional view illustrating a first exemplary embodiment of a touch sensor, taken along the line D-D' illustrated in FIG. 14;
FIG. 16 is a sectional view illustrating a second exemplary embodiment of a touch sensor, taken along the line D-D' illustrated in FIG. 14;
FIG. 17 is a flowchart illustrating a method of coupling the door cover and the touch sensor illustrated in FIG. 11;
FIG. 18 is a flowchart illustrating a detailed step of attaching the touch sensor to the door cover in the structure illustrated in FIG. 12;
FIG. 19 is a sectional view taken along the line E-E' illustrated in FIG. 4; and
FIG. 20 is a conceptual view illustrating the door cover and a door frame in a separated state at a part F illustrated in FIG. 4.

### DETAILED DESCRIPTION OF THE INVENTION

Description will now be given in detail of a laundry treating apparatus according to the present invention, with reference to the accompanying drawings.

A singular representation may include a plural representation unless it represents a definitely different meaning from the context.

Although different embodiments are illustrated, the same or equivalent components to the foregoing embodiment may be provided with the same or similar reference numbers, and description thereof will not be repeated.

In describing the present invention, moreover, the detailed description will be omitted when a specific description for publicly known technologies to which the invention pertains is judged to obscure the gist of the present invention.

The accompanying drawings are used to help easily understand various technical features and it should be understood that the embodiments presented herein are not limited by the accompanying drawings.

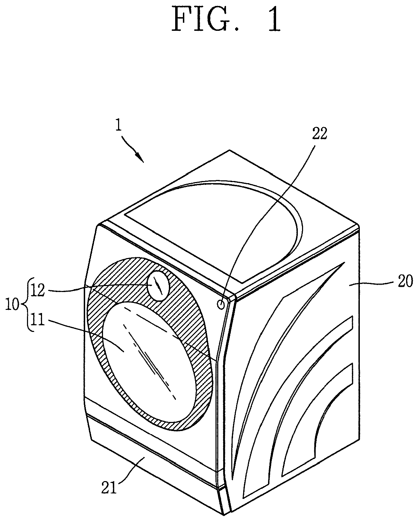

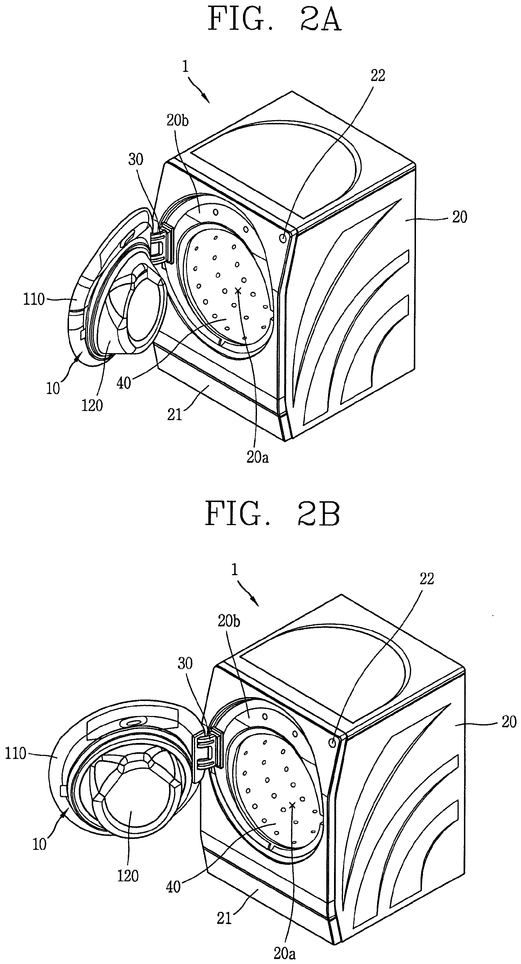

FIG. 1 is a perspective view of a laundry treating apparatus 1 in accordance with one exemplary embodiment of the present invention, FIGS. 2A and 2B are conceptual views illustrating an open state of a laundry introduction opening 20a, in response to primary and secondary rotations of a door 10 illustrated in FIG. 1, respectively.

Referring to those drawings, the laundry treating apparatus 1 includes a main body 20 and a door 10.

The main body 20 may define an appearance of the laundry treating apparatus 1, and is provided with a laundry introduction opening 20a through which laundry is introduced into the main body 20. This exemplary embodiment illustrates that the laundry introduction opening 20a is formed at a front portion of the main body 20 in a hexahedral shape.

The main body 20 may have therein a laundry accommodating unit in which the laundry is accommodated through the laundry introduction opening 20a.

For example, in case where the laundry treating apparatus 1 according to the present invention is implemented as an apparatus for drying laundry, the laundry accommodating unit may be configured as a drum 40 which is rotatably provided in the main body 20.

As another example, in case where the laundry treating apparatus 1 according to the present invention is implemented as an apparatus which can perform both washing and drying of laundry, the laundry accommodating unit may be configured by a tub (not illustrated) provided in the main body 20 to store washing water, and a drum 40 rotatably provided in the tub to accommodate the laundry therein.

The main body 20 may be provided with a driving unit (not illustrated) that rotates the drum 40. The driving unit may include a motor generating a driving force, and a belt rotating the drum 40 using the driving force.

The main body 20 may be provided with a detergent supply unit (not illustrated) that is installed to be pulled out and pushed in like a drawer. A cover 21 covering the detergent supply unit may be configured to be rotatable up and down.

The main body 20 may be provided with a power button 22 to turn the laundry treating apparatus 1 on/off. When a display portion 12 to be explained later is configured as a touch screen, the laundry treating apparatus 1 can be turned on/off by applying a touch input to the touch screen 12. In this instance, the power button 22 may not be employed and thus more simplified appearance of the laundry treating apparatus 1 can be implemented.

The door 10 may be relatively movable with respect to the main body 20 to open and close the laundry introduction opening 20a. As illustrated, the door 10 may be installed to be rotatable with respect to the main body 20 centering on a hinge unit 30.

The main body 20 may be provided with a door accommodating portion 20b recessed into an outer surface thereof and having the laundry introduction opening 20a therein. When the door 10 is closed, the door 10 may be accommodated in the door accommodating portion 20b, and an edge of an outer surface of the door 10 may be flush with an adjacent outer surface of the main body 20.

With regard to the structure that the door 10 is accommodated in the door accommodating portion 20b, in order to prevent the door 10 from being stopped at the main body 20, the hinge unit 30 may have a dual-hinge structure having two different rotation shafts. In this instance, as illustrated in FIGS. 2A and 2B, the door 10 may be spaced apart from the door accommodating portion 20b by a primary rotation centering on one of the two rotation shafts, and thereafter rotated by a secondary rotation centering on the other rotation shaft.

In the structure that the hinge unit 30 is mounted to one side of the door 10, a locking device for locking or unlocking the door 10 with respect to the main body 20 may be provided on another side of the door 10. The locking device may be configured in a pressing manner. Accordingly, the door 10 may be locked when the another side of the door 10 is pressed once, and unlocked when pressed once again.

The door 10 may be provided with a window portion 11 and a display portion 12.

In a closed state of the door 10, the window portion 11 may be disposed to face the laundry introduction opening 20a, such that the inside of the laundry accommodating unit is visible therethrough. The window portion 11 may thus allow a user to check a state of the laundry accommodated in the laundry accommodating unit therethrough.

The display portion 12 may output information processed in the laundry treating apparatus 1. For example, the display portion 12 may output execution screen information regarding strokes (washing, dehydrating, drying, etc.) performed in the laundry treating apparatus 1, or user interface (Ul) or graphic user interface (GUI) information corresponding to the execution screen information.

Hereinafter, a detailed structure of the door 10 will be described.

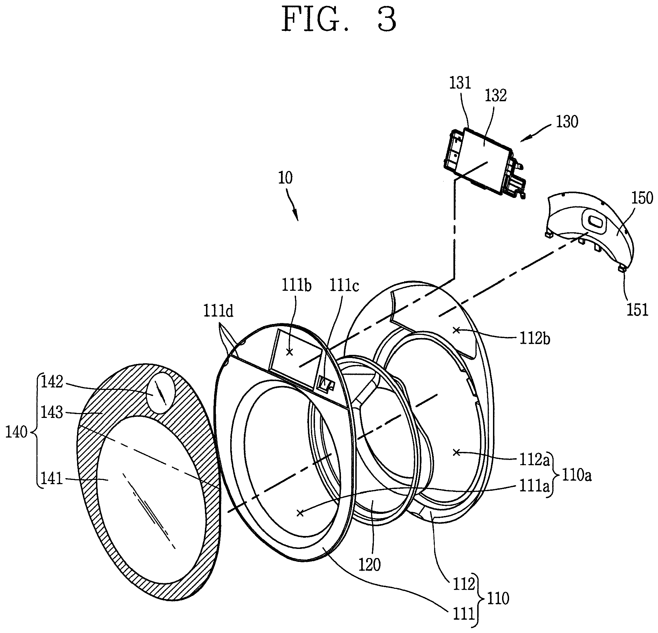

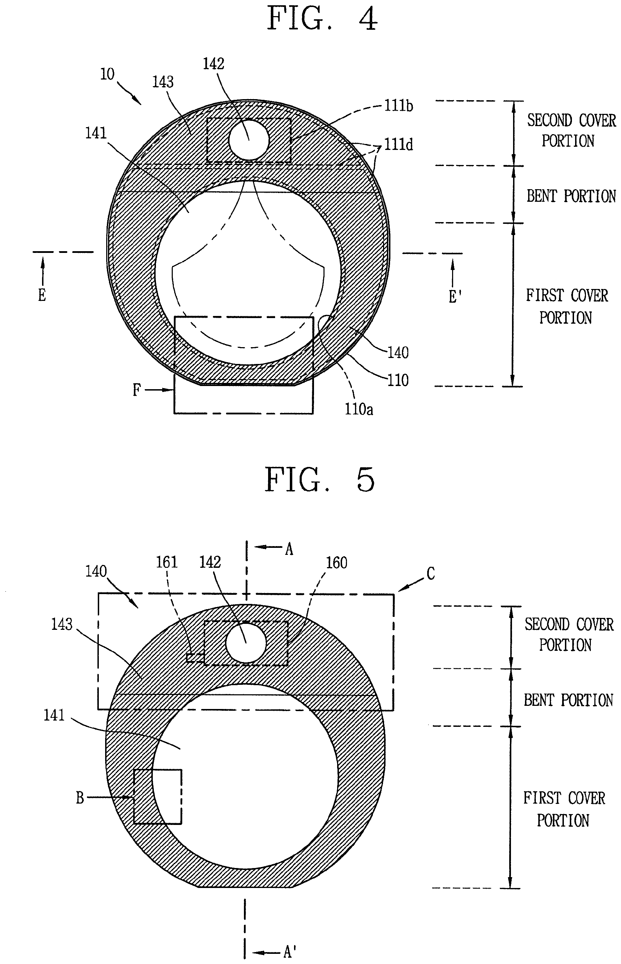

FIG. 3 is a disassembled perspective view of the door 10 illustrated in FIG. 1, and FIG. 4 is a front view of the door 10 illustrated in FIG. 1.

As illustrated in FIGS. 3 and 4, the door 10 may include a door frame 110, a door window 120, a display module 130 and a door cover 140. As aforementioned, the door 10 is provided with the hinge unit 30 for coupling with the main body 20, but the hinge unit 30 is omitted in this drawings.

This exemplary embodiment illustrates that the door 10 is formed in a circular shape (including a perfectly circular shape, an oval shape, or a circular shape with at least part rounded). However, the present invention may not be necessarily limited to this shape. The door 10 may also be formed in a polygonal shape (a rectangular shape, a hexagonal shape, etc.).

The door frame 110 may be rotatably coupled to the main body 20, and to this end, the hinge unit 30 may be coupled to the door frame 110 and the main body 20, respectively.

As illustrated, the door frame 110 may include an outer frame 111 and an inner frame 112. The outer frame 111 and the inner frame 112 may be made of a synthetic resin material (e.g., ABS, PC, etc.).

For reference, those components are referred to as the outer frame 111 and the inner frame 112 because the outer frame 111 faces the outside of the main body 20 and the inner frame 112 faces the inside of the main body when viewing only the door frame 110 in the closed state of the door 10. Alternatively, the outer frame 111 and the inner frame 112 may also be referred to as first and second frames, respectively, without such distinguishment.

The door frame 110 may include a first opening portion 110a facing the laundry introduction opening 20a, and a second opening portion 111b corresponding to the display module 130 mounted inside, in the closed state of the door 10. The first opening portion 110a may also be referred to as a window hole in the aspect that the door window 120 is disposed at the first opening portion 110a, and the second opening portion 111b may also be referred to as a display hole in the aspect that the display module 130 is disposed at the second opening portion 111b. The second opening portion 111b may be located above the second opening portion 110a.

The first opening portion 110a may include a front opening 111a formed through the outer frame 111, and a rear opening 112a formed through the inner frame 112. The second opening portion 111b may be formed through the outer frame 111. A communicating portion 112b may be formed above the rear opening 112a of the inner frame 112. The display module 130 may be mounted in the door frame 110 through the communicating portion 112b.

The door window 120 may be installed at the door frame 110 to correspond to the first opening portion 110a. The door window 120 may be made of a transparent material (glass, synthetic resin materials, etc.) and disposed to face the laundry introduction opening 20a in the closed state of the door 10.

The display module 130 may be disposed in the door frame 110. The display module 130 comprises a mounting frame 131 and a display 132. The display module 130 may be disposed to correspond to (be aligned with) the second opening portion 111b, and the display 132 provided on the mounting frame 131 may output visual information related to information processed in the laundry treating apparatus 1.

In addition, a flexible printed circuit board (FPCB) hole 111c through which a FPCB 161 (see FIG. 5) of a touch sensor 160 is inserted may be formed at the door frame 110. In the drawings, the FPCB hole 111c is located at one side of the second opening portion 111b.

The door cover 140 which defines an appearance of the door 10 may be coupled to the door frame 110. The door cover 140 may be made of a glass material or a synthetic resin material having transmittance (or transparency).

The door cover 140 includes an opaque region 143, and may include a first transparent region 141 corresponding to the first opening portion 110a and a second transparent region 142 corresponding to the second opening portion 111b within the opaque region 143. Here, a transparent region (or light transmitting region) refers to a region through which at least part of light is transmitted such that an opposite side or inside is visible. Therefore, the transparent region can be understood as a conception including a semitransparent region.

The first and second transparent regions 141 and 142 may be divided by the opaque region 143. In this exemplary embodiment, the door frame 110 and the door cover 140 are formed in a circular shape to correspond to the circular door 10, and the first and second transparent regions 141 and 142 are formed in a circular shape to make the user feel unity from the integrated shape. Here, the circular shape includes a circle, an oval or a circular shape with at least part rounded.

For reference, the formation of those components into the circular shape is merely illustrative, and the present invention may not be limited to this. For example, the first and second transparent regions 141 and 142 may be formed in a polygonal shape (e.g., rectangle, hexagon, etc.) and other geometric shapes, in addition to the circular shape.

The door cover 140 may have at least part formed in a bent shape. For example, based on the bent portion of the door cover 140, first and second cover portions at both sides of the bent portion may be inclined toward each other. Here, the first cover portion and the second cover portion may be formed in a flat shape. To correspond to the shape of the door cover 140, the door frame 110 may also have at least part formed in a bent shape.

In this exemplary embodiment, the first transparent region 141 is formed over the first cover portion and the bent portion, and the second transparent region 142 is formed at the second cover portion.

Meanwhile, the second transparent region 142 may be smaller than the second opening portion 111b in size, and disposed within the second opening portion 111b in an overlapping manner in a state that the door cover 140 is coupled to the door frame 110. Here, the overlapping refers to overlapping in a thickness direction of the door 10. According to such arrangement, an outer line forming the second opening 111b is not visible due to the opaque region 143.

Also, the display module 130 is disposed in the second opening 111b. The second transparent region 142 may be disposed within the display 132, which is provided on the display module 130, in an overlapping manner. According to the arrangement, with merely externally exposing only the display 132 for outputting visual information, other device structures (e.g., the mounting frame 131) may not be externally exposed by virtue of the opaque region 143, which may result in implementing more simplified appearance of the door 10.

In addition, an edge region (i.e., bezel region) of the display 132 corresponds to a substantially non-output region of visual information due to a limitation of design. If the edge region is disposed within the second transparent region 142, the visual information output on the display 132 may be output on a smaller screen than the second transparent region 142. In this instance, the user can feel like the output screen of the visual information is smaller than an actual size.

To solve this problem, the edge region of the display 132, on which any visual information is not output, may be disposed to be covered with the opaque region 143. According to the arrangement, the visual information output on the display 132 may construct a screen which completely corresponds to (is fully fit to) the second transparent region 142. In this instance, the user may feel like the output screen of the visual information is greater than an actual size, and accordingly can be more immersed in the screen.

As illustrated, the second opening portion 111b may have a rectangular shape corresponding to the rectangular display module 130, and the second transparent region 142 may have a circular shape disposed in the second opening portion 111b in the overlapping manner. That is, the second transparent region 142 may be disposed to overlap a part of the display module 130, and the opaque region 143 may be disposed to obscure another part of the display module 130. With the configuration, visual information can be output only through a portion of the display module 130 corresponding to the second transparent region 142, thereby providing the user with the display portion 12 in the circular shape.

The circular display is more expensive than a rectangular display which is generally widely used, and also difficult to set an accurate installation position in view of its shape, which may frequently cause a defective assembly. However, with employing such structure according to the present invention, the rectangular display 132 which requires for less fabricating costs and can be assembled at an accurate position can be used and also the display portion 12 which looks circular can be provided to the user.

The second transparent region 142 may be surrounded by the opaque region 143, and accordingly visual information which is output on a portion of the display 132 which does not correspond to the second transparent region 142 may be invisible to the user. Considering this, the visible information may not be output on the portion of the display 152 which does not correspond to the second transparent region 142.

For example, while visual information related to information processed in the laundry treating apparatus 1 is output on a portion of the display 132 corresponding to the second transparent region 142, an outer image surrounding the visual information may be output on the portion of the display 132 without corresponding to the second transparent region 142. The outer image may be a portion which does not correspond to the second transparent region 142, and be filled with a specific color tone (e.g., black).

As another example, in a state that the visual information processed in the laundry treating apparatus 1 is output on the portion of the display 132 corresponding to the second transparent region 142, the portion of the display 132 without corresponding to the second transparent region 142 may be turned off. That is, the portion of the display 132 without corresponding to the second transparent region 142 may not output any outer image as well as the visual information. In this exemplary embodiment, only the part of the display 132 may be turned on, accordingly, the display 132 can be more efficiently driven than the foregoing embodiment of turning on the entire display 132, resulting in obtaining a power saving effect.

FIG. 5 is a rear view of the door cover 140 illustrated in FIG. 3.

The display portion 12 disposed on the door cover 140 may be interlayered or integrated with the touch sensor 160, thereby implementing the touch screen 12. The touch screen 12 may function as a user input unit which provides an input interface between the laundry treating apparatus 1 and the user and simultaneously provide an output interface between the laundry treating apparatus 1 and the user. For example, selection and change of an operation mode for performing washing, dehydrating and drying strokes can be realized by applying a user's touch input (or touch) to the display portion 12.

The touch sensor 160 may be provided on the door 10 to sense a touch sensor applied to the door cover 140.

The touch sensor 160 may sense a touch input, which is applied to the display portion (or touch screen) 12 in at least one of various touch manners, such as a resistive manner, a capacitive manner, an infrared manner, an ultrasonic type, a magnetic manner and the like.

As one example, the touch sensor 160 may convert a change of pressure applied to a specific portion of the touch screen 12 or capacitance generated at the specific portion into an electrical input signal. The touch sensor 160 may be configured to detect touch position, touch area, touch pressure and the like, which are made by a touch object applying a touch to the touch screen. Here, the touch object may be an object applying a touch onto the touch sensor 160, for example, a finger, a touch pen, a stylus pen, a pointer or the like.

In this manner, when a touch input(s) is(are) applied to the touch sensor 160, the touch sensor 160 may send a corresponding signal(s) to a control unit. The control unit may then transmit which area of the display portion 12 has been touched. Here, the control unit may be a separate component from the controller or the controller itself.

Meanwhile, the controller may perform different controls or the same control according to a type of a touch object applying a touch to the touch screen 12. Whether to perform a different control or the same control according to the type of the touch object may be decided according to an operating state of the laundry treating apparatus 1 or a currently-executed application program.

The touch sensor 160 may sense various types of touches applied to the touch screen 12. Examples of the various types of touches may include a short (or tap) touch, a long touch, a multi touch, a drag touch, a flick touch, a pinch-in touch, a pinch-out touch, a swipe touch, a hovering touch and the like.

The touch sensor 160 may sense a touch input applied to a sensing region including the second transparent region 142.

This exemplary embodiment illustrates that the touch sensor 160 is attached to a rear surface of the door cover 140 in a manner of covering the second transparent region 142 and a part of the opaque region 143 surrounding the second transparent region 142. With the configuration, the sensing region of the touch sensor 160 may also include even the part of the opaque region surrounding the second transparent region 142 as well as the second transparent region 142. Therefore, various Uls or GUIs using the part of the opaque region 143 surrounding the second transparent region 142 can be provided.

In the structure, the touch sensor 160 may be formed in a shape of a touch film providing a touch pattern, and disposed between the door cover 140 and the display module 130. The touch film may be made of a transparent conductive film, and indium-tin oxide (ITO) film, carbon nano tube (CNT) film and the like can be used as the touch film.

The touch film may be configured into one layer or two layers. For example, when the touch film forms two layers (glass-film-film (GFF)), the touch film may be attached to the rear surface of the door cover 140 or on the display module 130. As another example, when the touch film forms one layer, the touch film may be attached to the rear surface of the door cover 140 into an integral form.

The touch sensor 160 may also be configured in a manner of patterning a metal wire directly onto the rear surface of the door cover 140 without a separate touch film [G2: Glass only].

Or, the touch sensor 160 may be integrally formed with the display 132 provided on the display module 130. For example, the touch sensor 160 may be disposed on a substrate of the display 132 (on-cell) or within the display 132 (in-cell).

Meanwhile, the display portion 12 of the laundry treating apparatus 1 may be driven under the control of the controller. That is, the controller may control On/Off of the display module 130, an output of visual information or image, and On/Off of the touch sensor 160.

Here, the controller may control whether or not to activate sensing of a touch applied to a portion of the sensing region of the touch sensor 160, which does not correspond to the second transparent region 142. For example, by determining whether or not it is necessary to sense a touch applied to the portion of the sensing region of the touch sensor 160 without corresponding to the second transparent region 142, the touch sensing with respect to the non-corresponding portion may be deactivated in the unnecessary state of the touch sensing. According to the control, an error which is likely to occur when the user applies a touch input can be reduced and a power-saving effect can be obtained.

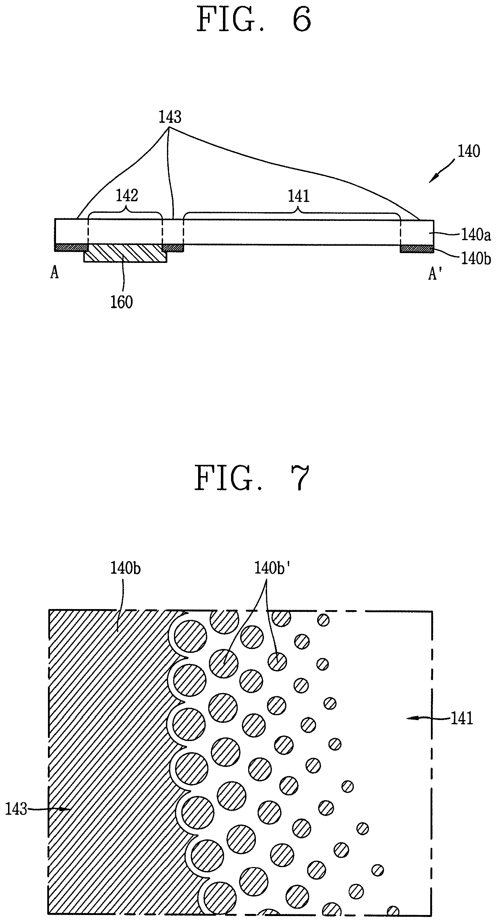

FIG. 6 is a sectional view illustrating a first exemplary embodiment of the door cover 140, taken along the line A-A' of FIG. 5.

Referring to FIG. 6, the door cover 140 may include a cover body 140a and a shielding layer 140b.

The cover body 140a may be made of a transparent material. The cover body 140a may also be made of a transparent glass material or a synthetic resin material. The cover body 140a may have at least part formed in a bent shape.

The shielding layer 140b may shield one surface of the cover body 140a so as to form the opaque region 143. The shielding layer 140b may be formed on a front or rear surface of the cover body 140a.

This exemplary embodiment illustrates that the shielding layer 140b is formed by printing ink onto the rear surface of the cover body 140a. The ink may contain a pigment with a specific color tone (e.g., black, white, blue, etc.). The shielding layer 140b may alternatively be formed by various printing methods, such as screen printing (using a mesh made of silk, nylon, tetron, stainless steel, etc.), offset printing, transfer printing, and the like.

As illustrated, the shielding layer 140b may not be disposed on the first and second transparent regions 141 and 142. In other words, the first and second transparent regions 141 and 142 may be transparent portions on which the transparent cover body 140a is left without being shielded by the shielding layer 140b.

The shielding layer 140b is formed to surround the first and second transparent regions 141 and 142. The first and second transparent regions 141 and 142 are divided by the opaque region 143 which is formed by the shielding layer 140b.

The touch sensor 160 is attached to the rear surface of the cover body 140a corresponding to the second transparent region 142. The touch sensor 160 is disposed to completely cover the second transparent region 142 so as to detect a touch input applied to the second transparent region 142. The touch sensor 160 may be greater than the second transparent region 142 in size. In this instance, the touch sensor 160 may be configured to cover a part of the shielding layer 140b defining the second transparent region 142.

Meanwhile, with the structure, the transparent touch sensor 160 and the transparent cover body 140a are sequentially disposed at the front side of the display 132 provided on the display module 130.

FIG. 7 is an enlarged view of a part B illustrated in FIG. 5.

As illustrated in FIG. 7, the shielding layer 140b which defines the first transparent region 141 of the door cover 140 may be configured such that transparency thereof gradually changes toward the first transparent region 141.

For example, the opaque region 143 around the first transparent region 141 may gradually be transparent toward the first transparent region 141. To this end, the shielding layer 140b may include a plurality of shielding dots 140b' which are formed around the first transparent region 141. The plurality of shielding dots 140b' may be configured to have density which is gradually lowered toward the first transparent region 141.

By blurring a boundary of the first transparent region 141 by such halftone technique, the region from the opaque region 143 up to the first transparent region 141 can be naturally viewed.

On the other hand, the second transparent region 142 and the opaque region 143 surrounding it may obviously be divided by the opaque region 143 in a form of a boundary.

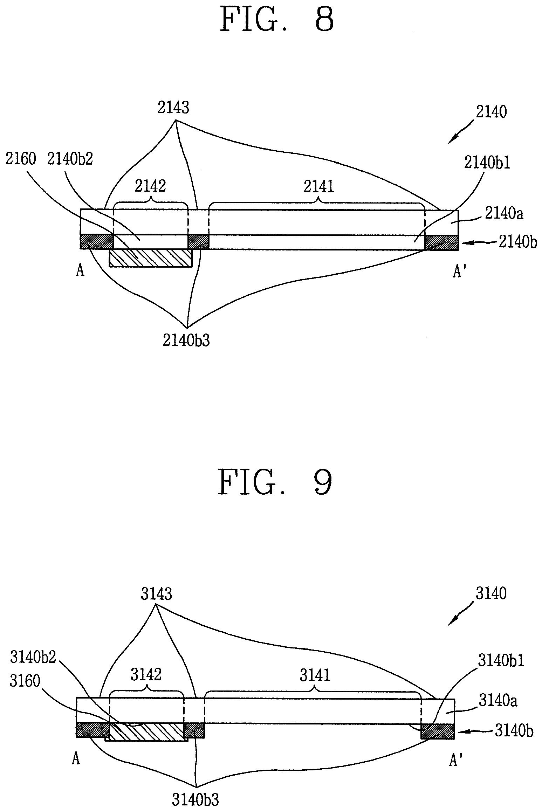

FIG. 8 is a sectional view illustrating a second exemplary embodiment of the door cover 140, taken along the line A-A' of FIG. 5.

Unlike the foregoing first embodiment in which the shielding layer 140b is printed on the rear surface of the cover body 140a, this exemplary embodiment illustrates that a film 2140b for forming an opaque region 2143 is attached to a rear surface of a cover body 2140a.

As illustrated in FIG. 8, the film 2140b may include an opaque portion 2140b3 corresponding to the opaque region 2143, a first transparent portion 2140b1 corresponding to a first transparent region 2141, and a second transparent portion 2140b2 corresponding to a second transparent region 2142. The opaque portion 2140b3 may be configured to surround the first and second transparent portions 2140b1 and 2140b2. The first and second transparent portions 2140b1 and 2140b2 may be divided from each other by the opaque portion 2140b3.

Here, a portion corresponding to the opaque portion 2140b3 may function as a shielding layer, which makes a door cover 2140 opaque, and form the opaque region 2143. Portions corresponding to the first and second transparent portions 2140b1 and 2140b2 may form the first and second transparent regions 2141 and 2142, respectively, along with the transparent cover body 2140a.

That is, unlike the foregoing first exemplary embodiment, the first and second transparent regions 2141 and 2142 may be formed by arranging transparent portions of the film 2140b, namely, the first and second transparent portions 2140b1 and 2140b2, on the transparent cover body 2140a.

A touch sensor 2160 is attached to a rear surface of the film 2140b corresponding to the second transparent portion 2140b2. The touch sensor 2160 is disposed to completely cover the second transparent region 2142 so as to detect a touch input applied to the second transparent region 2142. The touch sensor 2160 may be greater than the second transparent region 2142 in size. In this instance, the touch sensor 2160 may cover a part of the opaque portion 2140b3 limiting the second transparent portion 2140b2.

Meanwhile, with the structure, the transparent touch sensor 2160, the second transparent portion 2140b2 of the film 2140b and the transparent cover body 140a are sequentially disposed at the front side of the display 132 provided on the display module 130.

FIG. 9 is a sectional view illustrating a third exemplary embodiment of the door cover 140, taken along the line A-A' of FIG. 5.

Similar to the foregoing second exemplary embodiment, this exemplary embodiment illustrates that a film 3140b for forming a shielding layer 3140b is attached to a rear surface of a cover body 3140a. As illustrated in FIG. 9, the film 3140b may include an opaque portion 3140b3 corresponding to an opaque region 3143, a first hole 3140b1 corresponding to a first transparent region 3141, and a second hole 3140b2 corresponding to a second transparent region 3142. The opaque portion 3140b3 may surround the first and second holes 3140b1 and 3140b2, and the first and second holes 3140b1 and 3140b2 may be divided by the opaque portion 3140b3.

Here, a portion corresponding to the opaque portion 3140b3 may function as a shielding layer which makes the door cover 3140 opaque, and form the opaque region 3143. The first and second holes 3140b1 and 3140b2 may be formed at portions corresponding to the first and second transparent regions 3141 and 3142. Accordingly, the first and second holes 3140b1 and 3140b2 may expose the transparent cover body 3140a therethrough without the film 3140b arranged thereon.

A touch sensor 3160 is attached to a rear surface of the cover body 3140a corresponding to the second transparent region 3142. The touch sensor 3160 is disposed to completely cover the second transparent region 3142 so as to detect a touch input applied to the second transparent region 3142. The touch sensor 3160 may be greater than the second transparent region 3142 in size. In this instance, the touch sensor 3160 may cover a part of the opaque portion 3140b3 limiting the second hole 3140b2.

Meanwhile, with the structure, the transparent touch sensor 3160 and the transparent cover body 3140a are sequentially disposed at the front side of the display 132 provided on the display module 130. This may be substantially the same as the layered structure illustrated in FIG. 6, with a slight difference of the thickness between the shielding layers 140b and 3140b.

The layered structures illustrated in FIGS. 6 and 9 provide the following effects, as compared with the layered structure illustrated in FIG. 8.

First, the touch sensor 160, 3160 is attached directly onto the transparent cover body 140a, 3140a, which can increase touch sensitivity that the user feels. Also, unlike the layered structure illustrated in FIG. 8, the second transparent portion 2140b2 of the film 2140b is not provided at the front of the display 132, which may allow visual information output on the display 132 to be more clearly provided.

Meanwhile, the method of attaching the film 2140b, 3140b onto the door cover 2140, 3140 illustrated in FIGS. 8 and 9 may be an in-mold injection, a transfer method, and the like.

The in-mold injection is a method which may be used when the door cover 2140, 3140 is made of synthetic resin, namely, a method in which the film 2140b, 3140b is disposed in a mold and integrally formed with the door cover 2140, 3140. The transfer method is a method of attaching the film 2140b, 3140b onto the door cover 2140, 3140 made of glass or synthetic resin through heat transfer pressing.

Meanwhile, in order to implement the touch screen 12 on the door 10, the touch sensor 160 and the display module 130 should be aligned with the second transparent region 142 of the door cover 140. Meanwhile, in the structure that the touch sensor 160 is not provided on the display module 130 but configured separate from the display module 130 to be attached to the rear surface of the door cover 140, the touch sensor 160 should be attached to an accurate position of the door cover 140 to ensure reliability of the touch screen 12.

Therefore, it may be important to align the touch sensor 160 with the second transparent region 142 and the display module 130. Among others, during an assembly process, the touch sensor 160 should be attached to a preset position of the door cover 140 to ensure an alignment with the display module 130 which is to be assembled therewith later.

Hereinafter, description will be given of a coupling structure of the touch sensor 160 with respect to the door cover 140 considering such alignment.

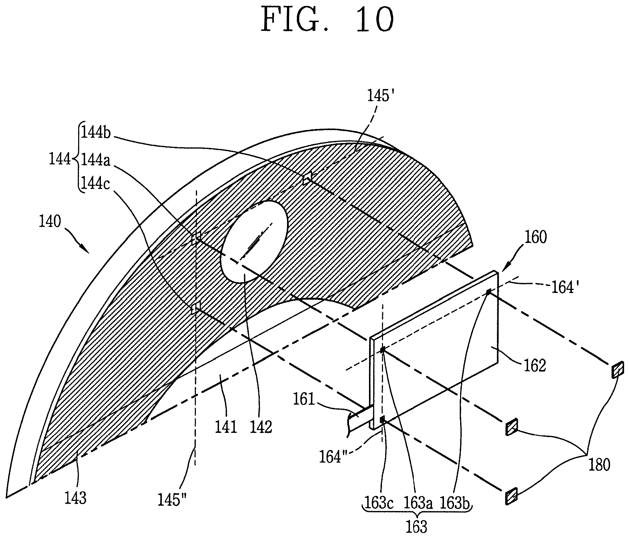

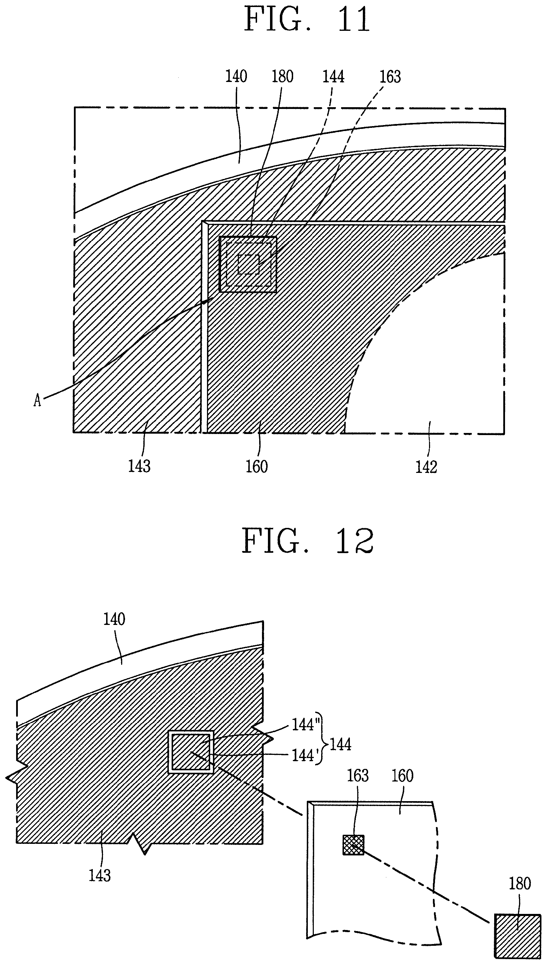

FIG. 10 is a conceptual view illustrating a separated state between the door cover 140 and the touch sensor 160 at a part C illustrated in FIG. 5, and FIG. 11 is an enlarged view of the part C illustrated in FIG. 5.

As illustrated in FIGS. 10 and 11, an align mark 163 may be formed on the touch sensor 160, and a guide mark 144 for guiding an attachment position of the touch sensor 160 using the align mark 163 may be formed on the door cover 140. The align mark 163 and the guide mark 144 may help setting the attachment position of the touch sensor 160 with respect to the door cover 140.

The touch sensor 160 may be formed in a circular shape (perfect circle, oval, etc.) as well as a polygonal shape (rectangle, hexagon, etc.). However, considering that the touch sensor 160 is a component for implementing the display portion 12 as the touch screen, the touch sensor 160 may preferably be formed in a shape corresponding to the display module 130. FIGS. 10 and 11 exemplarily illustrate that the touch sensor 160 has a rectangular shape corresponding to the rectangular display module 130.

The touch sensor 160 may have a larger size than the second transparent region 142 so as to cover the second transparent region 142 formed on the door cover 140. Therefore, a part of the touch sensor 160 may be disposed to cover the second transparent region 142 and another part thereof may be disposed to cover the opaque region 143 around the second transparent region 142. On the another part of the touch sensor 160 which covers the opaque region 143 may be formed the align mark 163 which is an attachment reference point of the touch sensor 160 with respect to the door cover 140.

The align mark 163 may be provided in plurality, and disposed on at least three points of the touch sensor 160 in a spaced manner. When the align mark 163 includes a first align mark 163a, a second align mark 163b and a third align mark 163c, a first virtual align line 164' connecting the first align mark 163a and the second align mark 163b may intersect with a second virtual align line 164" connecting the first align mark 163a and the third align mark 163c.

The align mark 163 may be formed at a corner portion of the touch sensor 160 which does not correspond to the second transparent region 142. FIG. 10 exemplarily illustrates that the first to third align marks 163a, 163b and 163c are located on each corner portion of the touch sensor 160 and the first and second virtual align lines 164' and 164" are arranged perpendicular to each other.

The guide mark 144 may be formed on the opaque region 143 of the door cover 140, and include a transparent portion 144' (see FIG. 12) to be visually distinguishable within the opaque region 143. The guide mark 144 may be formed in plurality, arranged on a plurality of points around the second transparent region 142.

The guide mark 144 may be provided to correspond to the align mark 163. The guide mark 144 may be provided in plurality, arranged on at least three points of the door cover 140 in a spaced manner. When the guide mark 144 includes a first guide mark 144a, a second guide mark 144b and a third guide mark 144c, a first virtual guide line 145' connecting the first guide mark 144a and the second guide mark 144b may intersect with a second virtual guide line 145" connecting the first guide mark 144a and the second guide mark 144c.

With the configuration, the touch sensor 160 can be more accurately aligned with the door cover 140, and also may be more accurately aligned with the display module 130 which is to be assembled later, thereby ensuring reliability of the touch screen 12.

The guide mark 144 may be formed on the opaque region 143 surrounding the second transparent region 142. FIG. 10 exemplarily illustrates that the first to third guide marks 144a, 144b and 144c are located on the opaque region 143 around the second transparent region 142, and the first virtual guide line 145' and the second virtual guide line 145" are arranged perpendicular to each other.

When the first to third align marks 163a, 163b and 163c are arranged to correspond to the first to third guide marks 144a, 144b and 144c, respectively, the touch sensor 160 can be in an aligned state with the door cover 140. When the touch sensor 160 is attached to the rear surface of the door cover 140, the align mark 163 may be arranged in the guide mark 144 in an overlapping manner.

Meanwhile, since the guide mark 144 has the transparent portion 144' to be visually distinguished within the opaque region 143, at least part of the transparent portion 144' may not be obscured even though the touch sensor 160 is attached to the door cover 140, which may allow the user to visually distinguish the at least part of the transparent portion 144'. This, however, may interfere with implementing a simple appearance of the door.

To solve this, in the state that the front surface of the touch sensor 160 is attached to the rear surface of the door cover 140, a shielding member 180 which is opaque (non-transparent) may be attached to the rear surface of the touch sensor 160 to cover the guide mark 144. The shielding member 180 may preferably have the same color tone as the color of the opaque region 143. The shielding member 180 may have a shape of a film or a thin pad.

In this manner, the shielding member 180 may be configured to obscure the transparent portion 144' of the guide mark 144, which can make it difficult for the user to identify the guide mark 144.

Hereinafter, an alignment structure between the door cover 140 and the touch sensor 160 according to the shape of the guide mark 144 will be described.

FIG. 12 is a conceptual view illustrating a first exemplary embodiment of a structure for the alignment between the touch sensor 160 and the door cover 140 illustrated in FIG. 11.

Referring to FIG. 12, the guide mark 144 may include a transparent portion 144' and an opaque portion 144" within the transparent portion 144'.

The transparent portion 144' may surround the opaque portion 144" so as to divide the opaque portion 144" and the opaque region 143. That is, the transparent portion 144' may be formed within the opaque region 143 and the opaque region 144" may be formed within the transparent portion 144'.

This drawing exemplarily illustrates that the transparent portion 144' is formed in a shape of a closed loop completely surrounding the opaque portion 144". However, this embodiment may not be limited to this. The transparent portion 144" may be formed in a shape of an open loop surrounding a part of the opaque portion 144".

The opaque portion 144" may be formed of the same material as the opaque region 143. Also, the opaque portion 144" and the opaque region 143 may have the same color tone (e.g., black).

The transparent portion 144' may be a portion which is excluded upon forming the opaque region 143. For example, the transparent portion 144' may be portion which is excluded upon printing an opaque material for forming the opaque region 143 on the rear surface of the door cover 140 [see the description related to the shielding layer 140b (FIG. 6)], namely, a portion on which only the transparent cover body 140a is left.

In this manner, when the guide mark 144 includes the transparent portion 144' and the opaque portion 144" within the transparent portion 144', the user can hardly identify the guide mark 144 by virtue of the formation of the opaque portion 144" within the transparent portion 144' even though the guide mark 144 is recognized as a separate component within the opaque region 143 due to the transparent portion 144'.

When the align mark 163 is arranged within the opaque portion 144", the touch sensor 160 may be aligned with the door cover 140. That is, in the state that the front surface of the touch sensor 160 is attached to the rear surface of the door cover 140, the align mark 163 may be arranged within the opaque portion 144" in an overlapping manner.

The align mark 163 may have a different color tone from the opaque portion 144". Accordingly, the align mark 163 overlapped within the opaque portion 144" can be easily recognized, which may result in improving convenience in the assembly process.

Meanwhile, in the state that the touch sensor 160 has been attached to the door cover 140, the opaque shielding member 180 may be attached to the rear surface of the touch sensor 160 in a manner of covering the transparent portion 144' of the guide mark 144. The shielding member 180 may be configured to cover both of the transparent portion 144' and the opaque portion 144" or formed in a loop shape corresponding to the transparent portion 144'.

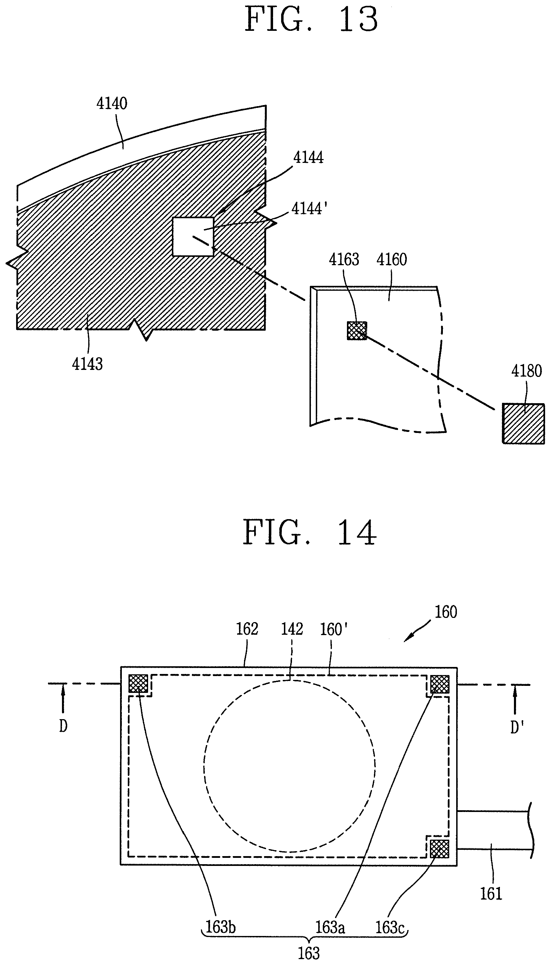

FIG. 13 is a conceptual view illustrating a second exemplary embodiment of a structure for the alignment between the touch sensor 160 and the door cover 140 illustrated in FIG. 11.

Referring to FIG. 13, the guide mark 144 may be configured fully as a transparent portion 4144' which is distinguished from an opaque region 4143.

The transparent portion 4144' may be a portion which is excluded upon forming the opaque region 4143. For example, the transparent portion 4144' may be a portion excluded upon printing an opaque material for forming the opaque region 4143 on a rear surface of a door cover 4140 [see the description related to the shielding layer 140b (FIG. 6)], namely, a portion on which only the transparent cover body 140a is left.

When an align mark 4163 is arranged within the transparent portion 4144', the touch sensor 4160 may be aligned with the door cover 4140. That is, when the front surface of the touch sensor 4160 is attached to the rear surface of the door cover 4140, the align mark 4163 may be arranged within the transparent portion 4144' in an overlapping manner.

Since the guide mark 4144 corresponds to the entire transparent portion 4144', the align mark 4163 which is arranged within the transparent portion 4144' in the overlapping manner may be externally exposed through the transparent door cover 4140. In the structure, the align mark 4163 may have the same color tone as the opaque region 4143 such that the user can be difficult to recognize the align mark 4163.

In this manner, when the guide mark 4144 is configured fully as the transparent portion 4144', a size of the guide mark 4144 can be more reduced than that in the foregoing first exemplary embodiment further including the opaque portion 4144". Also, since the align mark 4163 is aligned within the transparent portion 4144' in the overlapping manner, the alignment can be more facilitated than that in the first exemplary embodiment of aligning the align mark 4163 within the opaque region 4144" in the overlapping manner.

Meanwhile, when the touch sensor 4160 is attached to the door cover 4140, an opaque shielding member 4180 may be attached to the rear surface of the touch sensor 160 to cover the transparent portion 4144' of the guide mark 4144.

Hereinafter, a detailed structure of the touch sensor 160 in relation to the align mark 163 will be described.

FIG. 14 is a front view of the touch sensor 160 illustrated in FIG. 11.

As illustrated in FIG. 14, the touch sensor 160 may include a sensing region 160' sensing a touch input applied to the door cover 140, and the second transparent region 142 may be overlaid within the sensing region 160'.

In addition, to sense a touch input applied to the opaque region 143 around the second transparent region 142, the sensing region 160' may be configured to overlap even the opaque region 143. In the configuration, a part of the sensing region 160' may overlap the second transparent region 142, and another part thereof may overlap the opaque region 143 around the second transparent region 142.

The align mark 163 provided on the touch sensor 160 may be located at a portion where the sensing region 160' is not formed. FIG. 14 exemplarily illustrates that the align mark 163 is provided on a corner portion of the touch sensor 160.

The touch sensor 160 may be provided with a flexible printed circuit board (FPCB) 161 which serves as a path for transmitting an input signal sensed by the touch sensor 160 to a control unit. The FPCB 161 may have a shape extending from one side of a touch sensor film 162.

Hereinafter, a layered structure of the touch sensor 160 will be described.

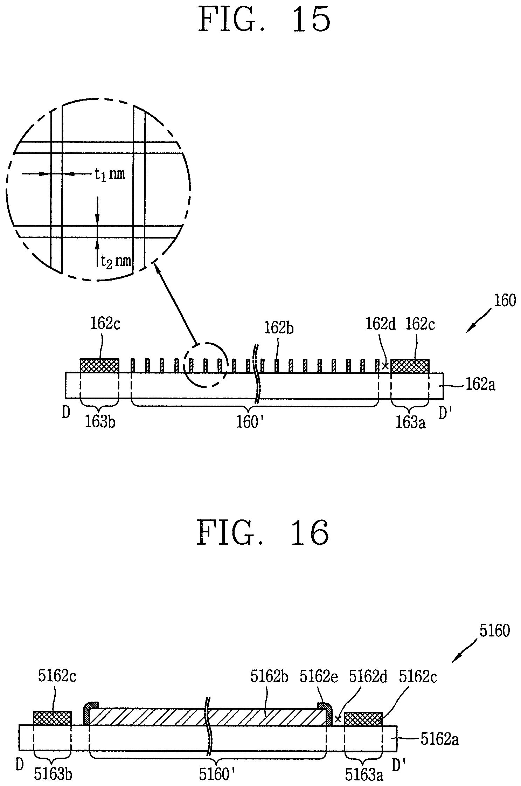

FIG. 15 is a sectional view illustrating a first exemplary embodiment of the touch sensor 160, taken along the line D-D' illustrated in FIG. 14.

As illustrated in FIG. 15, the touch sensor 160 may include a base portion 162a, a touch pattern portion 162b, and a mark portion 162c.

The base portion 162a may define an appearance of the touch sensor 160, and be made of an insulating material. The base portion 162a may be made of a transparent material such that visual information output on the display module 130 can be transmitted therethrough.

The touch pattern unit 162b forming the sensing region 160' of a touch input may be formed on the base portion 162a. The touch pattern portion 162b may be configured in a manner that metal members extend in a first direction (x-axis) and a second direction (y-axis), respectively, to form a grid pattern. The metal member may be made of a metallic material, such as silver (Ag), copper (Cu), gold (Au) and the like.

The metallic material forming the touch pattern portion 162b may have thin line widths (t1, t2) (nano-scale). Therefore, the touch pattern portion 162b may neither be identified with the user's eyes, and nor interfere with visual information output from the display module 130.

The metallic materials extending in the first direction and the second direction may be insulated from each other at an overlapped portion. To this end, an insulating layer may be interposed at the overlapped portion.

The touch pattern portion 162b may be electrically connected with the FPCB 161 directly or indirectly (through a separate signal transfer portion).

The mark portion 162c constructing the align mark 163 [163a, 163b] may be formed on the base portion 162a. The mark portion 162c may be formed of the same material as the touch pattern portion 162b, and electrically separated from the touch pattern portion 162b.

To implement this, the mark portion 162c and the touch pattern portion 162b may be formed during the same process, not through separate processes from each other. For example, a metallic material deposited on the base portion 162a may be divided into the touch pattern portion 162b and the mark portion 162c through masking, etching, and the like. In this instance, the mark portion 162c may be electrically separated from the touch pattern portion 162b by an etched portion 162d.

That is, the mark portion 162c may be formed of the same metallic material as the touch pattern portion 162b, but understood as a dummy portion which is electrically separated from the touch pattern portion 162b and thus cannot sense a touch input. With the structure, the mark portion 162c may be arranged to form the same layer with the touch pattern portion 162b on the base portion 162a.

The mark portion 162c may be patterned to have a predetermined area, and configured to be identified with the user's eyes, unlike the metal member constructing the touch pattern portion 162b. The mark portion 162c may have an opaque property, and as aforementioned, may have a different color tone from the opaque portion 144" [the first embodiment related to FIG. 12] or have the same color tone as the opaque region 4143 [the second embodiment related to FIG. 13].

This structure can have an advantage of providing a simple layered structure in view of forming the pattern portion 162b and the mark portion 162c using the single metallic material. Also, the structure can use a relatively cheap metallic material, and thus have an advantage of substituting an ITO transparent electrode containing indium which is a high-priced rare metal called a rare earth metal.

FIG. 16 is a sectional view illustrating a second exemplary embodiment of a touch sensor 5160, taken along the line D-D' illustrated in FIG. 14.

As illustrated in FIG. 16, a touch sensor 5160 may include a base portion 5162a, a touch pattern portion 5162b, a signal transfer portion 5162e, and a mark portion 5162c.

The base portion 5162a may define an appearance of the touch sensor 5160, and be made of an insulating material. The base portion 5162a may be formed of a transparent material such that visual information output on the display module 5130 can be transmitted therethrough.

The touch pattern portion 5162b forming a sensing region 5160' of a touch input may be formed on the base portion 5162a. The touch pattern portion 5162b may be implemented in a manner of depositing a transparent conductive film, such as indium tin oxide (ITO), carbon nano tube (CNT) and the like, on the base portion 5162a.

The touch pattern portion 5162b may include first and second pattern layers which extend in a first direction (x-axis) and a second direction (y-axis), respectively, to construct sensing channels. This drawing conceptually illustrates the touch pattern layer for easily describing a connection between the touch pattern portion 5162b and the signal transfer portion 5162e.

The touch pattern portion 5162b may be connected with the signal transfer portion 5162e, and the signal transfer portion 5162e may be connected with the FPCB 5161. That is, the signal transfer portion 5162e may electrically connect the touch pattern portion 5162b with the FPCB 5161, to transfer a touch input signal which is sensed by the touch pattern portion 5162b. The signal transfer portion 5162e may be made of a colored material, but may not be externally exposed by being obscured by the opaque region 5143 of the door cover 5140.

The mark portion 5162c forming marks 5163a and 5163b may be formed on the base portion 5162a. The mark portion 5162c may be electrically separated from the touch pattern portion 5162b and the signal transfer portion 5162e. The mark portion 5162c may be patterned to have a predetermined area, and thus recognizable by the user with the eyes, unlike the touch pattern portion 5162b.

The mark portion 5162c may have an opaque property, and as aforementioned, have a different color tone from that of the opaque portion 144" [the first embodiment related to FIG. 12] or have the same color tone as that of the opaque region 4143 [the second embodiment related to FIG. 13].

The mark portion 5162c may be made of the same material as the signal transfer portion 5162e, but electrically separated from the signal transfer portion 5162e. To implement this, the mark portion 5162c and the signal transfer portion 5162e may be formed during the same process, other than through separate processes. For example, a metal material deposited on the base portion 5162a may be divided into the signal transfer portion 5162e and the mark portion 5162c through processes such as masking, etching and the like. In this instance, the mask portion 5162c may be electrically separated from the signal transfer portion 5162e by an etched portion 5162d.

Or, the mark portion 5162c may be made of a different material from the signal transfer portion 5162e and formed through different processes. In this instance, the touch sensor 5160 with the align marks 5163a and 5163b can be fabricated through a simple process of forming the mark portion 5162c on the prefabricated touch sensor 5160.

Hereinafter, a method of fabricating the door cover 140 coupled with the touch sensor 160 will be described.

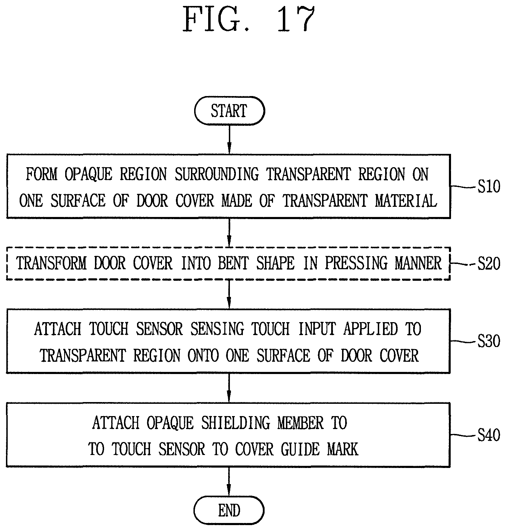

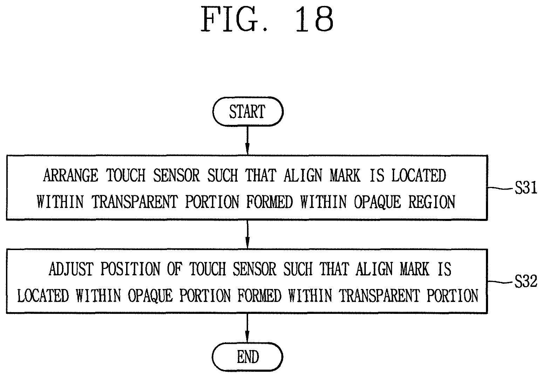

FIG. 17 is a flowchart illustrating a method of coupling the door cover 140 and the touch sensor 160 illustrated in FIG. 11, and FIG. 18 is a flowchart illustrating a detailed step of attaching the touch sensor 160 to the door cover 140, in the structure illustrated in FIG. 12.

Referring to FIG. 17, to fabricate the door cover 140, an opaque region 143 surrounding the second transparent region 142 may first be formed on one surface of the door cover 140, which is made of a transparent material (S10). As aforementioned, in order to form the second transparent region 142 and the opaque region 143 on the door cover 140, an opaque material may be printed on one surface of the door cover 140, or a film with the opaque portion 144" thereon may be attached to the one surface of the door cover 140.

Next, the touch sensor 160 sensing a touch input applied to the second transparent region 142 may be attached to the one surface of the door cover 140 (S30). The step of attaching the touch sensor 160 may include aligning the align mark 163 of the touch sensor 160 to be overlaid within the guide mark 144 formed on the opaque region 143.

With regard to this, in the first embodiment illustrated in FIG. 12, the align mark 163 may be aligned within the guide mark 144 through specialized steps, as follows.

Referring to FIG. 18, the touch sensor 160 may be aligned in a manner that the align mark 163 is located within the transparent portion 144' of the guide mark 144 (S31). Afterwards, the location of the touch sensor 160 may be adjusted such that the align mark 163 is located in the opaque portion 144" formed within the transparent portion 144' (S32). In this instance, the location of the touch sensor 160 may be precisely adjusted such that the aforementioned first to third align marks 163a, 163b and 163c are located within the opaque portions 144" of the first to third guide marks 144a, 144b and 144c, respectively.

The alignment can be realized by adjusting the location of the touch sensor 160 while the user checks it with the eyes or using a device, or in a completely automatic manner by using a device.

After the touch sensor 160 is attached to the door cover 140, the opaque shielding member 180 may be attached to the touch sensor 160 to cover the guide mark 144 (S40). The display module 130 may then be disposed to cover the second transparent region 142 of the door 10, thereby completely fabricating the touch screen 12.

Meanwhile, the door cover 140 may have at least part formed in a bent shape. To this end, after forming the opaque region 143, and before attaching the touch sensor 160 to the door cover 140, transforming the door cover 140 into a bent shape by pressing the door cover 140 may be added (S20).

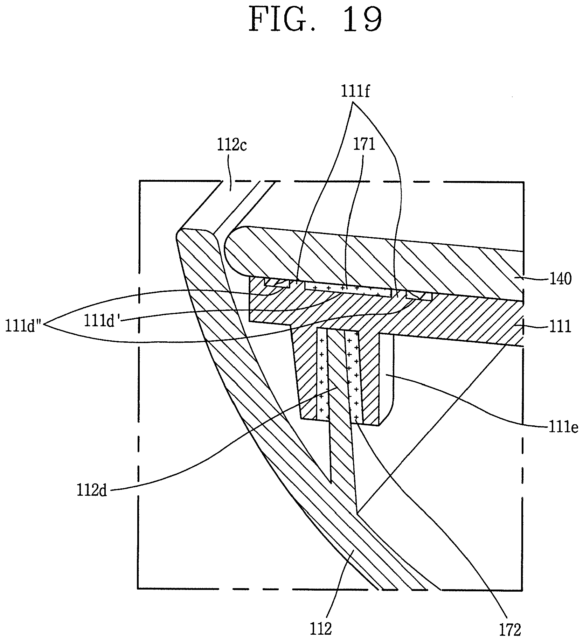

FIG. 19 is a sectional view taken along the line E-E' illustrated in FIG. 4.

As illustrated in FIG. 19, the door cover 140 may be coupled to the door frame 110. As aforementioned, the door frame 110 may include the outer frame 111 and the inner frame 112.

The outer frame 111 may be configured such that the door cover 140 is attached to a front surface of the outer frame 111. The inner frame 112 may be coupled at a rear side of the outer frame 111. The coupling between the outer frame 111 and the inner frame 112 may be implemented in a screw-coupling, hook-coupling, or bonding manner.

This drawing illustrates a coupled structure between the outer frame 111 and the inner frame 112 in the bonding manner. In detail, a coupling rib 112d may protrude from the inner frame 112 and a rib accommodating portion 111e in which the coupling rib 112d is accommodated may protrude from a rear surface of the outer frame 111, and a bonding member 172 may be filled in the rib accommodating portion 111e.

Meanwhile, when the outer frame 111 and the inner frame 112 are coupled to each other, an outer circumferential portion of the inner frame 112 may protrude at a front surface of the outer frame 111, thereby forming a mounting guide 112c. The mounting guide 112c may extend in a loop shape along a circumference of the outer frame 111, so as to form a space in which the door cover 140 is accommodated.

The mounting guide 112c may be disposed to cover a side surface of the door cover 140, and protrude by a predetermined height such that an upper surface of the mounting guide 112c can be flush with the upper surface of the adjacent door cover 140. With the configuration, a step between the mounting guide 112c and the door cover 140 can be reduced, thereby implementing a more simplified appearance.

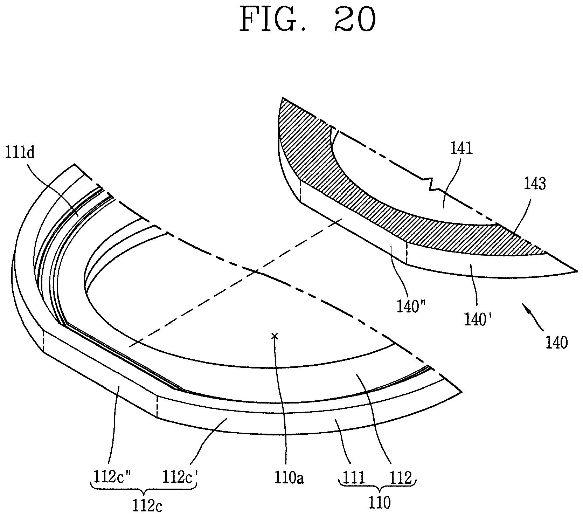

FIG. 20 is a conceptual view illustrating the door cover 140 and the door frame 110 in a separate state, at a part F illustrated in FIG. 4.

In general, portions with unique shapes (e.g., vertex (or corner) portions, recessed portions, etc.) may serve as reference points for fixing (aligning) an installation location during an assembly process so as to facilitate the assembly process. However, as illustrated in this embodiment, in case where the door cover 140 is formed in the circular shape, since an edge portion of the door cover 140 is rounded, it is not easy to find an appropriate portion for fixing (aligning) the installation location during the assembly process. Specifically, in the present invention, if the door cover 140 is not coupled to an accurate position on the door frame 110, the first and second transparent regions 141 and 142 of the door cover 140 may not correspond to or may be misaligned with the first and second opening portions 110a and 111b of the door frame 110.

To solve the problem, as illustrated in FIG. 20, the door cover 140 may have a reference portion (fitting point) for aligning an installation position upon being assembled with the door frame 110.

In detail, the door cover 140 may include a first edge portion 140' rounded into a circular shape, and a second edge portion 140" linearly connecting both sides of the first edge portion 140'. That is, the door cover 140 may have a circular shape with a part cut off into a linear shape.

The aforementioned mounting guide 112c may include a first protruding portion 112c' extending into a rounded shape to correspond to the first edge portion 140', and a second protruding portion 112c" extending into a linear shape to correspond to the second edge portion 140".

In the structure, the second edge portion 140" and the second protruding portion 112c" may become fitting points for aligning installation positions of the door cover 140 and the door frame 110 upon assembling them with each other. That is, when the second edge portion 140" is disposed to correspond to the second protruding portion 112c", the door cover 140 may be located at a fixed position on the door frame 110. This may allow the first and second transparent regions 141 and 142 of the door cover 140 to be aligned with the first and second opening portions 110a and 111b of the door frame 110.

Also, as the door cover 140 is located at the fixed position on the door frame 110, the touch sensor 160 attached to the door cover 140 and the display module 130 coupled to the door frame 110 can be aligned with each other. This may result in ensuring reliability of the touch screen 12.

The second protruding portion112c" may be located at any position of the door frame 110. However, the second protruding portion 112c" may preferably be formed at a lower side of the door frame 110 such that the user cannot easily recognize that the door 10 has a circular shape with a partially-cut portion.

Meanwhile, still referring to FIG. 20 along with FIG. 19, the door cover 140 may be coupled to the door frame 110 using a liquid sealant 171. A sealant filling groove 111d in which the sealant 171 is filled may be formed at a front surface of the outer frame 111.

The sealant filling groove 111d may include a sealant filled portion 111d' and a sealant collecting portions 111d".

The sealant filled portion 111d' which is a portion for filling the sealant 171 therein may surround the first opening portion 110a and the second opening portion 111b.

The sealant collecting portions 111d" for collecting the sealant 171 discharged to inner and outer sides of the sealant coating portion 111d" may be provided at both sides of the sealant filled portion 111d', respectively. The sealant collecting portions 111d" may extend in parallel along the sealant filled portion 111d' with being spaced apart from the sealant filled portion 111d' by a predetermined interval. The sealant collecting portions 111d" may have a narrower width than the sealant filled portion 111d'.

Jaws 111f may protrude between the sealant filled portion 111d' and the sealant collecting portions 111d" by a predetermined height. The jaws 111f may protrude by a height corresponding to the front surface of the outer frame 111. In this instance, the jaws 111f may function as support surfaces for supporting the door cover 140.

With the structure, even though the sealant 171 filled in the sealant filled portions 111d' is leaked out during the process of coupling the door cover 140 to the outer frame 111, the leaked sealant 171 may be collected in the sealant collecting portions 111d" provided at the inner and outer sides of the sealant filled portion 111d', respectively. This may result in preventing quality of appearance from being lowered due to the leaked sealant.

Also, with the structure, the sealant filled portion 111d' may be disposed as close as possible to the edge portion of the outer frame 111. Therefore, a non-bonded portion of the edge portion of the door cover 140 can be minimized, which may result in increasing bonding strength and effectively preventing an introduction of foreign materials through a gap between the door cover 140 and the outer frame 111.

## Claims

1. A laundry treating apparatus (1) comprising:
a main body (20) having a laundry introduction opening (20a); and
a door (10) capable of opening and closing the laundry introduction opening (20a),
wherein the door (10) comprises:
a door cover (140) defining an appearance of the door (10), and provided with a transparent region (142), and an opaque region (143) surrounding the transparent region (142);
a display module (130) disposed on a rear surface of the door cover (140), and capable of outputting visual information through the transparent region (142); and
a touch sensor (160) attached to a rear surface of the door cover (140) and capable of sensing a touch input applied to the transparent region (142),
wherein the touch sensor (160, 5160) is provided with an align mark (163), and the opaque region (143) is provided with a guide mark (144) capable of guiding an attachment position of the touch sensor (160, 5160) using the align mark (163),
**characterised in that** the guide mark (144) comprises:
an opaque portion (144"); and a transparent portion (144') formed to surround the opaque portion(144") and dividing the opaque portion (144") and the opaque region (143), so that the transparent portion (144') is formed within the opaque region (143) and the opaque portion (144") is formed within the transparent portion (144');
wherein the align mark is disposed within the opaque portion (144") in an overlapping manner, in a state where a front surface of the touch sensor (160, 5160) has been attached to the rear surface of the door cover (140),
wherein the door (10) further comprises an opaque shielding member (180) attached to a rear surface of the touch sensor (160, 5160) to cover the transparent portion (144") of the guide mark (144) in a state that the front surface of the touch sensor (160) has attached to the rear surface of the door cover (140),
wherein the opaque portion (144") and the opaque shielding member (180) have the same color tone as the opaque region (143), and
wherein the align mark (163) has a different color tone from the opaque portion (144").

2. The apparatus of claim 1, wherein the guide mark (144) is disposed on at least three points around the transparent region (142), in a spaced manner.

3. The apparatus of claim 1 or 2, wherein the align mark (163) is formed at a corner portion of the touch sensor (160, 5160).

4. The apparatus of any one of claims 1 to 3, wherein the touch sensor (160, 5160) comprises:
a base portion (162a, 5162a) made of a transparent material;
a touch pattern portion (162b, 5162b) formed on the base portion (162a, 5162a) to sense a touch input applied to the door cover (140); and
a mark portion (162c, 5162c) formed on the base portion (162a, 5162a) and forming the align mark (163).

5. The apparatus of claim 4, wherein the mark portion (162c) is made of the same material as the touch pattern portion (162b), but is electrically separated from the touch pattern portion (162b).

6. The apparatus of claim 4, wherein the touch sensor (5160) further comprises a signal transfer portion (5162e) electrically connected to the touch pattern portion (5162b) to form a signal transfer path, and
wherein the mark portion (5162c) is made of the same material as the signal transfer portion (5162e).

7. The apparatus of any one of claims 1 to 6, wherein the door cover (140) comprises:
a cover body (140a) made of a transparent material; and
a shielding layer (140b) disposed to cover a rear surface of the cover body (140a), and forming the opaque region (143).

8. The apparatus of claim 7, wherein the transparent region (142) is a portion where the shielding layer (140b) is not disposed.

9. A laundry treating apparatus (1), comprising:
a main body (20) having a laundry introduction opening (20a); and
a door (10) capable of opening or closing the laundry introduction opening (20a),
wherein the door (10) comprises:
a door cover (4140) defining an appearance of the door (10), and having a transparent region (142) and an opaque region (143) surrounding the transparent region (142);
a display module (130) provided on a rear surface of the door cover (4140), and capable of outputting visual information through the transparent region (142); and
a touch sensor (4160) attached to a rear surface of the door cover (4140) to cover the transparent region (142), and capable of sensing a touch input applied to the transparent region (142),
wherein the touch sensor (4160) is provided with an align mark (4163), and the opaque region (143) around the transparent region (142) is provided with a guide mark (4144) capable of guiding an attachment position of the touch sensor (4160) using the align mark (4163),
**characterised in that** the guide mark (4144) comprises only a transparent portion (4144') formed within the opaque region (143),
wherein the align mark (4163) is arranged within the transparent portion (4144') in an overlapping manner in a state where a front surface of the touch sensor (4160) has been attached to the rear surface of the door cover (4140),
wherein the door (10) further comprises an opaque shielding member (4180) attached to a rear surface of the touch sensor (4160) to cover the transparent portion (4144') of the guide mark (4144) in a state that a front surface of the touch sensor (160) has attached to the rear surface of the door cover (140),
wherein the align mark (4163) and the opaque shielding member (4180) have the same color tone as the opaque region (4143).

10. The apparatus of claim 9, wherein the guide mark (4144) is provided on at least three points around the transparent region (142), in a spaced manner.

11. The apparatus of claim 9 or 10, wherein the align mark (4163) is formed at a corner portion of the touch sensor (4160).

## Patentansprüche

1. Wäschebehandlungsvorrichtung (1), die aufweist:
einen Hauptkörper (20) mit einer Wäscheeinführöffnung (20a); und
eine Tür (10), die die Wäscheeinführungsöffnung (20a) öffnen und schließen kann,
wobei die Tür (10) aufweist:
eine Türabdeckung (140), die eine Erscheinung der Tür (10) definiert und einen transparenten Bereich (142) und einen den transparenten Bereich (142) umgebenden opaken Bereich (143) aufweist;
ein Anzeigemodul (130), das an einer hinteren Fläche der Türabdeckung (140) angeordnet ist und visuelle Informationen durch den transparenten Bereich (142) ausgeben kann; und
einen Berührungssensor (160), der an einer hinteren Fläche der Türabdeckung (140) befestigt ist und eine auf den transparenten Bereich (142) ausgeübte Berührungseingabe erkennen kann,
wobei der Berührungssensor (160, 5160) mit einer Ausrichtmarkierung (163) versehen ist und der opake Bereich (143) mit einer Führungsmarkierung (144) versehen ist, die eine Befestigungsposition des Berührungssensors (160, 5160) unter Verwendung der Ausrichtmarkierung (163) führen kann,
**dadurch gekennzeichnet, dass** die Führungsmarkierung (144) aufweist,
einen opaken Abschnitt (144"), und einen transparenten Abschnitt (144'), der so gebildet ist, dass er den opaken Abschnitt (144") umgibt und den opaken Abschnitt (144") und den opaken Bereich (143) teilt, so dass der transparente Abschnitt (144') im opaken Bereich (143) gebildet ist und der opake Abschnitt (144") im transparenten Abschnitt (144') gebildet ist;
wobei in einem Zustand, in dem eine vordere Fläche des Berührungssensors (160, 5160) an der hinteren Fläche der Türabdeckung (140) befestigt wurde, die Ausrichtmarkierung in überlagernder Weise im opaken Abschnitt (144") angeordnet ist,
wobei die Tür (10) ferner aufweist:
ein opakes Abschirmelement (180), das an einer hinteren Fläche des Berührungssensors (160, 5160) befestigt ist, um den transparenten Abschnitt (144") der Führungsmarkierung (144) in einem Zustand abzudecken, in dem die vordere Fläche des Berührungssensors (160) an der hinteren Fläche der Türabdeckung (140) befestigt wurde,
wobei der opake Abschnitt (144") und das opake Abschirmelement (180) denselben Farbton wie der opake Bereich (143) haben, und
wobei die Ausrichtmarkierung (163) einen anderen Farbton als der opake Abschnitt (144") hat.

2. Vorrichtung nach Anspruch 1, wobei die Führungsmarkierung (144) an mindestens drei Punkten um den transparenten Bereich (142) herum in beabstandeter Weise angeordnet ist.

3. Vorrichtung nach Anspruch 1 oder 2, wobei die Ausrichtmarkierung (163) an einem Eckabschnitt des Berührungssensors (160, 5160) gebildet ist.

4. Vorrichtung nach einem der Ansprüche 1 bis 3, wobei der Berührungssensor (160, 5160) aufweist:
einen Basisabschnitt (162a, 5162a) aus transparentem Material;
einem Berührungsmusterabschnitt (162b, 5162b), der auf dem Basisabschnitt (162a, 5162a) gebildet ist, um eine auf die Türabdeckung (140) ausgeübte Berührungseingabe zu erkennen; und
einen Markierungsabschnitt (162c, 5162c), der auf dem Basisabschnitt (162a, 5162a) gebildet ist und die Ausrichtmarkierung (163) bildet.

5. Vorrichtung nach Anspruch 4, wobei der Markierungsabschnitt (162c) aus demselben Material wie der Berührungsmusterabschnitt (162b) besteht, aber elektrisch vom Berührungsmusterabschnitt (162b) getrennt ist.

6. Vorrichtung nach Anspruch 4, wobei der Berührungssensor (5160) ferner einen Signalübertragungsabschnitt (5162e) aufweist, der elektrisch mit dem Berührungsmusterabschnitt (5162b) verbunden ist, um einen Signalübertragungsweg zu bilden, und
wobei der Markierungsabschnitt (5162c) aus demselben Material wie der Signalübertragungsabschnitt (5162e) besteht.

7. Vorrichtung nach einem der Ansprüche 1 bis 6, wobei die Türabdeckung (140) aufweist:
einen Abdeckungskörper (140a) aus transparentem Material; und
eine Abschirmschicht (140b), die vorgesehen ist, um eine hintere Fläche des Abdeckungskörpers (140a) zu bedecken, und die den opaken Bereich (143) bildet.

8. Vorrichtung nach Anspruch 7, wobei der transparente Bereich (142) ein Abschnitt ist, in dem die Abschirmschicht (140b) nicht angeordnet ist.

9. Wäschebehandlungsvorrichtung (1), die aufweist:
einen Hauptkörper (20) mit einer Wäscheeinführöffnung (20a); und
eine Tür (10), die die Wäscheeinführungsöffnung (20a) öffnen oder schließen kann,
wobei die Tür (10) aufweist:
eine Türabdeckung (4140), die eine Erscheinung der Tür (10) definiert und einen transparenten Bereich (142) und einen den transparenten Bereich (142) umgebenden opaken Bereich (143) aufweist;
ein Anzeigemodul (130), das an einer hinteren Fläche der Türabdeckung (4140) angeordnet ist und visuelle Informationen durch den transparenten Bereich (142) ausgeben kann; und
einen Berührungssensor (4160), der an einer hinteren Fläche der Türabdeckung (4140) befestigt ist, um den transparenten Bereich (142) abzudecken, und eine auf den transparenten Bereich (142) ausgeübte Berührungseingabe erkennen kann,
wobei der Berührungssensor (4160) mit einer Ausrichtmarkierung (4163) versehen ist und der opake Bereich (143) um den transparenten Bereich (142) mit einer Führungsmarkierung (4144) versehen ist, die eine Befestigungsposition des Berührungssensors (4160) unter Verwendung der Ausrichtmarkierung (4163) führen kann,
**dadurch gekennzeichnet, dass** die Führungsmarkierung (4144) nur einen im opaken Bereich (143) gebildeten transparenten Abschnitt (4144') aufweist,
wobei in einem Zustand, in dem eine vordere Fläche des Berührungssensors (4160) an der hinteren Fläche der Türabdeckung (4140) befestigt wurde, die Ausrichtmarkierung (4163) in überlagernder Weise im transparenten Abschnitt (4144') angeordnet ist,
wobei die Tür (10) ferner aufweist:
ein opakes Abschirmelement (4180), das an einer hinteren Fläche des Berührungssensors (4160) befestigt ist, um den transparenten Abschnitt (4144') der Führungsmarkierung (4144) in einem Zustand abzudecken, in dem eine vordere Fläche des Berührungssensors (160) an der hinteren Fläche der Türabdeckung (140) befestigt wurde,
wobei die Ausrichtmarkierung (4163) und das opake Abschirmelement (4180) denselben Farbton wie der opake Bereich (4143) haben.

10. Vorrichtung nach Anspruch 9, wobei die Führungsmarkierung (4144) an mindestens drei Punkten um den transparenten Bereich (142) herum in beabstandeter Weise angeordnet ist.

11. Vorrichtung nach Anspruch 9 oder 10, wobei die Ausrichtmarkierung (4163) an einem Eckabschnitt des Berührungssensors (4160) gebildet ist.

## Revendications

1. Appareil de traitement du linge (1) comprenant :
un corps principal (20) ayant une ouverture d'introduction de linge (20a) ; et
une porte (10) pouvant ouvrir et fermer l'ouverture d'introduction de linge (20a),
dans lequel la porte (10) comprend :
un couvercle de porte (140) définissant une apparence de la porte (10) et prévu avec une région transparente (142) et une région opaque (143) entourant la région transparente (142) ;
un module d'affichage (130) disposé sur une surface arrière du couvercle de porte (140) et pouvant transmettre l'information visuelle à travers la région transparente (142) ; et
un capteur tactile (160) fixé sur une surface arrière du couvercle de porte (140) et pouvant détecter une entrée tactile appliquée sur la région transparente (142),
dans lequel le capteur tactile (160, 5160) est prévu avec une marque d'alignement (163) et la région opaque (143) est prévu avec une marque de guidage (144) pouvant guider une position de fixation du capteur tactile (160, 5160) en utilisant la marque d'alignement (163),
**caractérisé en ce que** la marque de guidage (144) comprend :
une partie opaque (144") ; et une partie transparente (144') formée pour entourer la partie opaque (144") et divisant la partie opaque (144") et la région opaque (143), de sorte que la partie transparente (144') est formée dans la région opaque (143) et la partie opaque (144") est formée à l'intérieur de la partie transparente (144') ;
dans lequel la marque d'alignement est disposée dans la partie opaque (144") d'une manière chevauchante, dans un état dans lequel une surface avant du capteur tactile (160, 5160) a été fixée sur la surface arrière du couvercle de porte (140),
dans lequel la porte (10) comprend en outre :
un élément de protection opaque (180) fixé à une surface arrière du capteur tactile (160, 5160) afin de recouvrir la partie transparente (144") de la marque de guidage (144) dans un état dans lequel la surface avant du capteur tactile (160) est fixée sur la surface arrière du couvercle de porte (140),
dans lequel la partie opaque (144") et l'élément de protection opaque (180) ont la même teinte de couleur que la région opaque (143), et
dans lequel la marque d'alignement (163) a une teinte de couleur différente de la partie opaque (144").

2. Appareil selon la revendication 1, dans lequel la marque de guidage (144) est disposée sur au moins trois points autour de la région transparente (142) d'une manière espacée.

3. Appareil selon la revendication 1 ou 2, dans lequel la marque d'alignement (163) est formée au niveau d'une partie de coin du capteur tactile (160, 5160).

4. Appareil selon l'une quelconque des revendications 1 à 3, dans lequel le capteur tactile (160, 5160) comprend :
une partie de base (162a, 5162a) réalisée avec un matériau transparent ;
une partie de modèle tactile (162b, 5162b) formée sur la partie de base (162a, 5162a) pour détecter une entrée tactile appliquée sur le couvercle de porte (140) ; et
une partie de marque (162c, 5162c) formée sur la partie de base (162a, 5162a) et formant la marque d'alignement (163).

5. Appareil selon la revendication 4, dans lequel la partie de marque (162c) est réalisée avec le même matériau que la partie de modèle tactile (162b), mais est électriquement séparée de la partie de modèle tactile (162b).

6. Appareil selon la revendication 4, dans lequel le capteur tactile (5160) comprend en outre une partie de transfert de signal (5162e) électriquement raccordée à la partie de modèle tactile (5162b) afin de former un passage de transfert de signal, et
dans lequel la partie de marque (5162c) est réalisée avec le même matériau que la partie de transfert de signal (5162e).

7. Appareil selon l'une quelconque des revendications 1 à 6, dans lequel le couvercle de porte (140) comprend :
un corps de couvercle (140a) réalisé avec un matériau transparent ; et
une couche de protection (140b) disposée pour recouvrir une surface arrière du corps de couvercle (140a) et former la région opaque (143).

8. Appareil selon la revendication 7, dans lequel la région transparente (142) est une partie dans laquelle la couche de protection (140b) n'est pas disposée.

9. Appareil de traitement du linge (1) comprenant :
un corps principal (20) ayant une ouverture d'introduction de linge (20a) ; et
une porte (10) pouvant ouvrir ou fermer l'ouverture d'introduction de linge (20a) ;
dans lequel la porte (10) comprend :
un couvercle de porte (4140) définissant une apparence de la porte (10) et ayant une région transparente (142) et une région opaque (143) entourant la région transparente (142) ;
un module d'affichage (130) prévu sur une surface arrière du couvercle de porte (4140) et pouvant transmettre l'information visuelle à travers la région transparente (142) ; et
un capteur tactile (4160) fixé sur une surface arrière du couvercle de porte (4140) afin de recouvrir la région transparente (142) et pouvant détecter une entrée tactile appliquée sur la région transparente (142),
dans lequel le capteur tactile (4160) est prévu avec une marque d'alignement (4163) et la région opaque (143) autour de la région transparente (142) est prévue avec une marque de guidage (4144) pouvant guider une position de fixation du capteur tactile (4160) à l'aide de la marque d'alignement (4163),
**caractérisé en ce que** la marque de guidage (4144) comprend uniquement une partie transparente (4144') formée dans la région opaque (143),
dans lequel la marque d'alignement (4163) est agencée dans la partie transparente (4144') d'une manière chevauchante dans un état dans lequel une surface avant du capteur tactile (4160) a été fixée sur la surface arrière du couvercle de porte (4140),
dans lequel la porte (10) comprend en outre :
un élément de protection opaque (4180) fixé sur une surface arrière du capteur tactile (4160) afin de recouvrir la partie transparente (4144') de la marque de guidage (4144) dans un état dans lequel une surface avant du capteur tactile (160) est fixée sur la surface arrière du couvercle de porte (140),
dans lequel la marque d'alignement (4163) et l'élément de protection opaque (4180) ont la même teinte de couleur que la région opaque (4143).

10. Appareil selon la revendication 9, dans lequel la marque de guidage (4144) est prévue sur au moins trois points autour de la région transparente (142) d'une manière espacée.

11. Appareil selon la revendication 9 ou 10, dans lequel la marque d'alignement (4163) est formée au niveau d'une partie de coin du capteur tactile (4160).
